Europäisches Patentamt

European Patent Office

Office européen des brevets

(11) Veröffentlichungsnummer: **0 030 007**

**A2**

(12) **EUROPÄISCHE PATENTANMELDUNG**

(21) Anmeldenummer: **80107396.6**

(22) Anmeldetag: **26.11.80**

(51) Int. Cl.³: **G 06 F 13/00**
**G 11 C 7/00, G 11 C 8/00**
**G 11 C 11/24**

(30) Priorität: **29.11.79 DE 2948159**

(43) Veröffentlichungstag der Anmeldung:
**10.06.81 Patentblatt 81/23**

(84) Benannte Vertragsstaaten:
**FR GB NL**

(71) Anmelder: **SIEMENS AKTIENGESELLSCHAFT Berlin und München**
**Postfach 22 02 61**
**D-8000 München 22(DE)**

(72) Erfinder: **Penzel, Hans-Jörg, Dipl.-Ing.**
**Weidacher Strasse 12**
**D-8190 Wolfratshausen(DE)**

(54) Integrierter Speicherbaustein mit wählbaren Betriebsfunktionen.

(57) Die Erfindung betrifft einen integrierten Speicherbaustein, dessen Betriebsfunktionen auch dann noch wählbar sind, wenn der Baustein bereits eingebaut ist.

Durch die Einführung eines beschreib- und lesbaren Modusregisters zur Aufnahme von Steuerinformationen zur Festlegung der gewünschten Betriebsfunktion, durch die Erweiterung der Adresseingänge zu bidirektionalen Bausteinnahtstellen und durch die Aufteilung des matrixartig aufgebauten Speichermediums in n (z. B. 8 bzw. 64) gleich große, mit dem höherwertigen Teil der Spaltenadresse gleichzeitig adressierbaren Bereiche wird eine erhebliche Erweiterung der Einsatzmöglichkeiten des Speicherbausteins erreicht. Ein interner Adresszähler erlaubt auch Zugriffe mit konsekutiven Spaltenadressen bei gleichbleibender Zeilenadresse.

Durch die Anpassungsfähigkeit des Speicherbausteins an unterschiedliche Anwendungsfälle kann die Typenvielfalt beträchtlich vermindert werden.

FIG 1

EP 0 030 007 A2

COMPLETE DOCUMENT

Croydon Printing Company Ltd.

SIEMENS AKTIENGESELLSCHAFT       Unser Zeichen
Berlin und München               VPA 79 P 2079 $\overline{\text{EUR}}$

Integrierter Speicherbaustein mit wählbaren Betriebsfunktionen.

Die Erfindung bezieht sich auf einen Speicherbaustein
nach dem Oberbegriff des Patentanspruchs 1.

Integrierte Speicherbausteine für den Aufbau von Schreib-
Lese-Speichern mit wahlfreiem Zugriff haben in den letzten
Jahren in kurzen Zeitabständen jeweils eine Vervierfachung ihrer Speicherkapazität erfahren. Derzeit sind 16
Kbit-Bausteine allgemein verfügbar (vergl. z.B. Memory
Data Book and Designers Guide, Mostek Corp., Carollton
USA, Febr. 1978, Seiten 107 bis 122) und 65 Kbit-Bausteine in der Erprobungsphase. 262 Kbit-Bausteine werden
vorbereitet.

Alle bekannten Speicherbausteine der hier betrachteten
Art weisen eine 1 Bit breite Datenschnittstelle auf. Mit
der Erhöhung der Speicherkapazität nimmt die Länge der
Adressen zu. Zur Einsparung von Anschlußpunkten (Pins) ist
man dazu übergegangen, die Gesamtadresse in zwei Teile gemäß der bausteininternen Zeilen- und Spaltenadresse aufzuteilen und die beiden Teile nacheinander über die glei-
She 1 Fdl/ 29. 11. 1979

chen Pins einzugeben. Die Adressenübernahme, die Weiterleitung an die internen Adressdecoder und die Aktivierung interner Taktserien geschieht durch entsprechende,
zeitlich versetzte Übernahmesignale.

Die Erhöhung der Speicherkapazität der einzelnen Speicherbausteine bringt auch eine beträchtliche Verringerung des spezifischen Platzbedarfs und der Zugriffszeit für die daraus aufgebauten Speicher mit sich. Da
andererseits die minimale, auf Speicherworte bezogene
Kapazität eines Speichers wegen der 1 Bit breiten Datenschnittstelle der Speicherbausteine gleich deren Kapazität in Bit ist, führt die fortlaufende Steigerung
der Speicherkapazität der Speicherbausteine zwangsläufig
zu Speichergrößen, die in manchen Fällen, wie beispielsweise beim Einsatz in Verbindung mit Mikroprozessoren oder
als Mikroprogramm-Pufferspeicher, unerwünscht sind.

Es ist daher die Aufgabe der Erfindung, in hoch integrierten Speicherbausteinen zusätzliche Einrichtungen
vorzusehen, damit diese bei voller Kompatibilität mit
konventionell ausgebildeten Speicherbausteinen auch nach
ihrer Fertigstellung an unterschiedliche Anwendungsfälle
angepaßt werden können. Gemäß der Erfindung weist ein
solcher Speicherbaustein die im kennzeichnenden Teil des
Patentanspruchs 1 aufgeführten Merkmale auf.

Durch die Maßnahmen gemäß der Erfindung ist es möglich,
in Abhängigkeit von der im Modusregister gespeicherten
Information folgende Lese- und Schreiboperationen auszuführen: 1 Bit, 4 Bit parallel, 8 bzw. 9 Bit parallel,
sowie bei gleichbleibender Zeilenadresse mehrere Bit
nacheinander mit willkürlichen Spaltenadressen und
schließlich 2, 4 oder 8 Zugriffe nacheinander bei gleichbleibender Zeilenadresse und konsekutiven Spaltenadressen,
wobei jeder Zugriff wahlweise 1 Bit oder 8 bzw. 9 Bit gleichzeitig umfassen kann. Dadurch kann eine Vielzahl spezieller Speicherbausteine durch einen Bausteintyp ersetzt werden. Die erforderliche Schaltungserweiterung beansprucht nur wenig zusätzliche Chipfläche.

Im folgenden wird die Erfindung anhand der Zeichnung näher beschrieben. Es zeigt darin:

Fig. 1 ein erstes Ausführungsbeispiel in Form eines Blockschaltbildes eines Speicherbausteins mit den für das Verständnis der Erfindung wesentlichen Schaltungselementen,

Fig. 2 Einzelheiten der Multiplexereinrichtung D-MUX nach Fig. 1,

Fig. 3 ein weiteres Ausführungsbeispiel der Erfindung,

Fig. 4 ein Impulsdiagramm "Lesen Modusregister",

Fig. 5 ein Impulsdiagramm "Schreiben mit fortlaufenden Spaltenadressen".

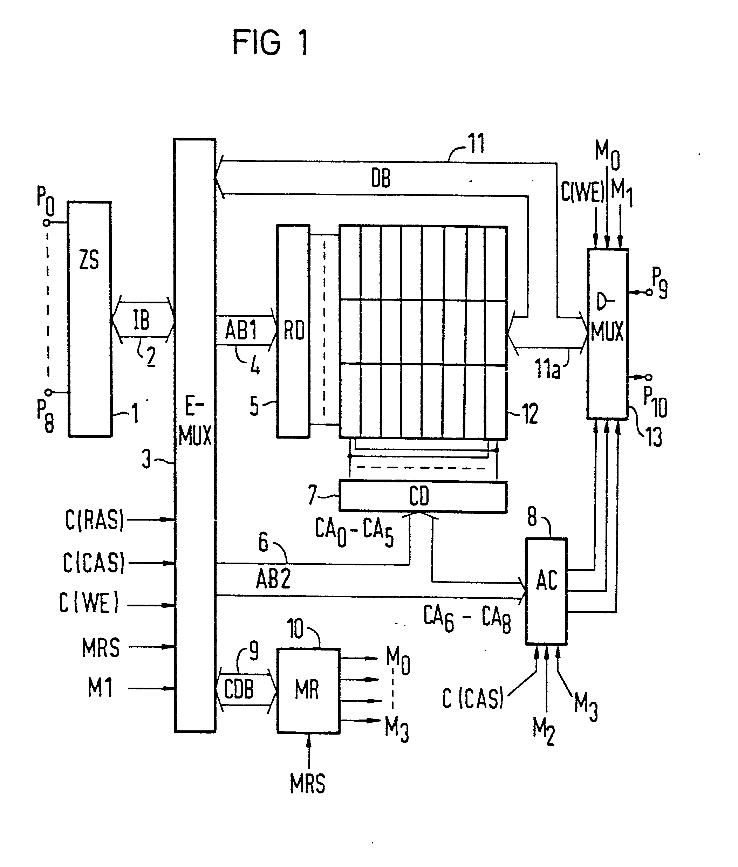

Die Fig. 1 gibt einen Überblick über die wesentlichen Schaltungselemente eines Speicherbausteins gemäß einem Ausführungsbeispiel der Erfindung. Der Darstellung und der folgenden Beschreibung ist eine Speicherkapazität von 262 Kbit zugrundegelegt, weshalb das Speicherfeld 512 Zeilen und Spalten enthält. Für bestimmte Zwecke, auf die noch eingegangen wird, kann die Erhöhung der Anzahl der Spalten auf 576 vorteilhaft sein. Die allgemeine Organisation des Speicherbausteins entspricht, von den durch die Erfindung gegebenen Besonderheiten abgesehen, der Organisation eines bekannten 16384x1 Bit-Speicherbausteins MK 4116 (vergl. die vorher genannte Firmendruckschrift der Mostek Corp.).

Gemäß der Fig. 1 ist mit den Anschlußklemmen $P_0$ bis $P_8$ eine Zwischenspeichereinrichtung 1 (ZS) verbunden, die hinsichtlich der Adresseneingabe dem Adressenpuffer des bekannten Speicherbausteins entspricht. Im Gegensatz dazu ist die Zwischenspeichereinrichtung 1 jedoch so ausgebildet, daß sie sowohl die Eingabe als auch die Ausgabe von Informationen in bzw. aus dem Speicherbaustein über die Pins $P_0$ bis $P_8$ erlaubt.

Ein Informationsbus 2 (IB) führt von der Zwischenspeichereinrichtung 1 zu einer Weichenschaltung 3 (E-MUX). Auch die Weichenschaltung 3 ist teilweise wieder für einen Zweirichtungsverkehr ausgebildet. Die Weichenschaltung 3 verbindet den Informationsbus 2 wahlweise über einen ersten Adressenbus 4 (AB1) mit einem Zeilenadressdecoder 5 (RD), über einen zweiten Adressenbus 6 (AB2) mit einem Spaltenadressdecoder 7 (CD) für die sechs höherwertigen Adressenbit ($CA_0$ bis $CA_5$) und mit einem Adresszähler 8 (AC) für die drei niederwertigen Adressenbit ($CA_6$ bis $CA_8$), über einen Steuerdatenbus 9 (CDB) mit einem Modusregister 10 (MR) zur Aufnahme von Steuerdaten zur Festlegung der Betriebsart des Speicherbausteins und schließlich mit einem Datenbus 11 (DB).

Die Steuerung der Weichenschaltung 3 erfolgt durch mehrere Signale. Die Signale C(RAS), C(CAS) und C(WE) sind abgeleitet von dem Übernahmesignal $\overline{RAS}$ für die Zeilenadresse, von dem Übernahmesignal $\overline{CAS}$ für die Spaltenadresse und von dem Schreib/Lese-Auswahlsignal $\overline{WE}$. Das Signal MRS bewirkt einen Zugriff zu dem Modusregister 10 und das Signal M1 ist ein Teil der im Modusregister 10 gespeicherten Steuerinformation, deren Bedeutung noch erklärt wird. Bezüglich der Steuerung der Weichenschaltung 3 hat das Signal MRS Vorrang von den Signalen $\overline{RAS}$ und $\overline{CAS}$.

Der Zeilenadressdecoder 5 wählt in bekannter Weise entsprechend der aktuellen Zeilenadresse eine der 512 Zeilen des Speicherfeldes 12 aus. Das Speicherfeld 12 besteht nach Fig. 1 aus einer oberen und unteren Hälfte, dazwischen befinden sich die Lese- und Regenerierverstärker. Die Daten-Eingabe und -Ausgabe geschieht über einen Datenbus, dessen einer Zweig 11, wie schon erwähnt, zu der Weichenschaltung 3 führt und dessen anderer Zweig 11a an einer Multiplexereinrichtung 13 (D-MUX) endet.

Das Speicherfeld 12 ist z. B. in acht Bereiche zu je 64 Spalten unterteilt. Alle Bereiche sind gleichzeitig adressierbar. Der Spaltenadressdecoder 7 ist daher so ausgebildet, daß er in jedem Bereich eine Spalte auswählt.

Die in das Modusregister 10 eingegebenen Steuerdaten werden zweckmäßig in zwei Gruppen zu je zwei Bit aufgeteilt. Die erste Gruppe mit den Bit $M_0$ und $M_1$ bestimmt dann beispielsweise die Breite der Datennahtstelle des Speicherbausteins und die zweite Gruppe mit den Bit $M_2$ und $M_3$ gibt die Anzahl der Schreib- oder Lesezugriffe mit konsekutiven Spaltenadressen an, die nachstehend als gekettete Zugriffe bezeichnet werden.

Den Bitgruppen kann dann z. B. folgende Bedeutung zugeordnet werden:

| $M_0$ | $M_1$ | Datenschnittstelle |
|---|---|---|
| 0 | 0 | 1 Bit |
| 1 | 0 | 4 Bit |
| 1 | 1 | 8 (9) Bit |

| $M_2$ | $M_3$ | gekettete Zugriffe |
|---|---|---|
| 0 | 0 | keine Kettung |
| 0 | 1 | 2 Zugriffe |
| 1 | 0 | 4 Zugriffe |
| 1 | 1 | 8 Zugriffe |

Konventionelle Betriebsarten wie Schreiben, Lesen,/Lesen-Ändern-Schreiben und Zugriffe mit variablen Spaltenadressen bei konstanter Zeilenadresse über eine 1-Bit-Datenschnittstelle (page mode) sind somit möglich für $M_0 = M_1 = M_2 = M_3 = 0$.

Für den externen Zugriff zum Modusregister steht eine 9 Bit breite Schnittstelle über die Pins $P_0$ bis $P_8$ zur Verfügung. Es ist deshalb vorteilhaft, das Modusregister 10 auf 9 Stellen zu erweitern und von den zusätzlich unterzubringenden Steuerinformationen z. B. zwei Bit $M_4$ und $M_5$ zur Steuerung interner Testabläufe und die restlichen Bit $M_6$ bis $M_8$ in an sich bekannter Weise zur Organisation von Ersatzschaltungen defekter Speicherbereiche (vergl. HMD, September 1979 (89), 8/3/8, Blatt 1 bis 3) zu verwenden. Der die Bit $M_6$ bis $M_8$ enthaltende Registerteil wird zweckmäßig als programmierbarer Festwertspeicher ausgeführt, der bereits vor der Fertigstellung des Speicherbausteins beschrieben wird. Sein Inhalt kann damit später nur noch gelesen werden. Grundsätzlich ist es auch möglich, die Kapazität des Modusregisters auf ein Vielfaches von 9 Bit, beispielsweise auf 18 Bit zu erhöhen. In diesem Fall muß noch eine Modusregisteradresse bereitgestellt werden, die mit dem Signal $\overline{RAS}$ in den Baustein übernommen wird, wenn gleichzeitig das Signal MRS anliegt. Darauf soll jedoch nicht näher eingegangen werden.

Bei nicht geketteten Speicherzugriffen (M2 ≙ M3 = 0) wirkt der Adresszähler 8 wie ein gewöhnliches Register zur Zwischenspeicherung des aus den Bit $CA_6$ bis $CA_8$ bestehenden Teils der Spaltenadresse. Die Eingabe erfolgt durch den schon erwähnten, intern erzeugten Signalimpuls C(CAS). Bei geketteten Zugriffen wird die jeweils gültige Teiladresse, von der ursprünglich eingegebenen Anfangsadresse ausgehend, mit jedem weiteren Impuls C(CAS) sukzessive um Eins erhöht. Die Grenzen der Adresserhöhung werden durch die Steuerbit M2 und M3 im Modusregister festgelegt. Zu diesem Zweck ist dem Adresszähler 8 ein in der Zeichnung nicht dargestellter vierstufiger Impulszähler zugeordnet, der mit dem Signal C(RAS) auf den durch die Steuerbit M2 und M3 codierten Binärwert 0010, 0100

oder 1000 voreingestellt und durch die Signalimpulse C(CAS) schrittweise zurückgezählt wird, bis der Zählerstand 0000 erreicht ist. Eine andere Möglichkeit besteht darin, einen dreistufigen Impulszähler durch das Signal C(RAS) auf den Anfangswert 111 einzustellen und über 000 hinweg bis zu dem um Eins verminderten Binärwert, z. B. 001 oder 011 oder 111, der durch die Steuerbit M2 und M3 bestimmt ist, hochzuzählen. Das Erreichen des jeweils vorgegebenen Endwerts wird durch einen Vergleicher festgestellt.

Die Multiplexereinrichtung 13, die über den Datenbus 11 bzw. 11a mit den Schreib/Leseleitungen im Speicherfeld 12 in Verbindung steht, hat die Aufgabe, entsprechend dem im Adresszähler 8 stehenden Teil der Spaltenadresse und in Abhängigkeit von den Steuerdaten im Modusregister 10 verschiedene Durchschalte- und Zwischenspeicherfunktionen auszuführen. Zu diesem Zweck werden der Multiplexereinrichtung 13 die Adressenbit $CA_6$ bis $CA_8$ aus dem Spaltenadresszähler 8 und die Bit $M_0$ und $M_1$ aus dem Modusregister 10 als Steuergrößen zugeführt. Ein von dem Schreib/Lese-Auswahlsignal $\overline{WE}$ abgeleitetes Signal C(WE) bestimmt die Übertragungsrichtung.

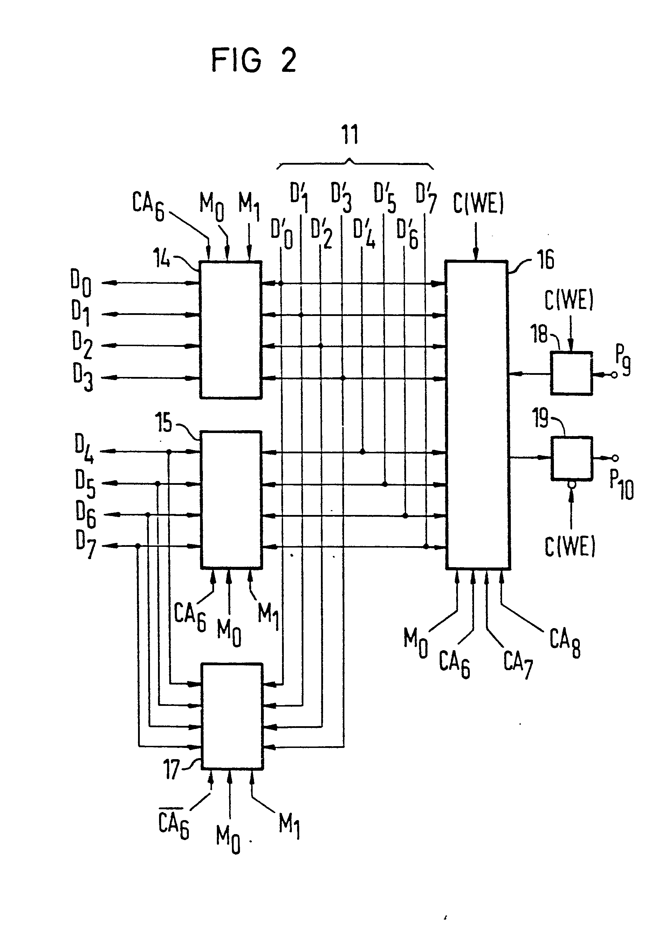

Einzelheiten der Multiplexereinrichtung 13 sind in Fig. 2 dargestellt. 8 Datenleitungen $D_0$ bis $D_7$ stellen die Verbindung zu den durch die höherwertigen Bit $CA_0$ bis $CA_5$ der Spaltenadresse ausgewählten Leseverstärkern bzw. Schreibleitungen her. Eine aus UND-Verknüpfungsgliedern bestehende, erste Schalteinrichtung 14 für bidirektionalen Betrieb schaltet die Datenleitungen $D_0$ bis $D_3$ auf die Datenleitungen $D'_0$ bis $D'_3$ durch, wenn die logische Beziehung $\overline{CA_6} \cdot M_1 + \overline{M_0} + \overline{M_1}$ erfüllt ist. Das Signal C(WE) legt die Übertragungsrichtung fest. Die Durchschaltung der Datenleitungen $D_4$ bis $D_7$ erfolgt mit Hilfe einer zweiten Schalteinrichtung 15. Sie wird bei Erfüllung der logi-

schen Beziehung $\overline{CA_6} \cdot M_0 \cdot M_1 + \overline{M_0 + M_1}$ durchlässig. Die Datenleitungen $D'_0$ bis $D'_7$ stehen mit einem Multiplexer 16 in
Verbindung und bilden auch den schon erwähnten Datenbus 11
(Fig. 1).

Eine dritte Schalteinrichtung 17, die wie die erste und
zweite Schalteinrichtung 14 und 15 ausgebildet ist, sperrt
oder stellt folgende Verbindungen der Datenleitungen her:
$D_4$ mit $D'_0$, $D_5$ mit $D'_1$, $D_6$ mit $D'_2$ und $D_7$ mit $D'_3$, wenn
die logische Beziehung $CA_6 \cdot M_0 \cdot \overline{M_1}$ erfüllt ist. Das Signal
C(WE) bestimmt wieder die Übertragungsrichtung.

Die Schalteinrichtungen dienen somit zur Umschaltung zwischen einer 4 Bit breiten und einer 8 Bit breiten Datenschnittstelle über die Anschlußpins $P_0$ bis $P_3$ bzw. $P_0$
bis $P_7$. Die Schalteinrichtungen 14, 15 und 17 können entfallen, wenn auf eine 4-Bit-Datenschnittstelle verzichtet
wird. Anstelle einer 8-Bit-Datenschnittstelle läßt sich
auch eine 9 Bit-Datenschnittstelle bilden, wenn das Speicherfeld 12 in 9 selbständige adressierbare Bereiche bei
entsprechender Anpassung des Spaltenadressdecoders 7 unterteilt wird. In diesem Fall ist beispielsweise die
Erhöhung der Anzahl der Spalten auf 576 zweckmäßig. Die
in der Zeichnung nicht dargestellte zugehörige Datenleitung $D_8$ umgeht die vorher genannten Schalteinrichtungen.

Der Multiplexer 16, dessen Übertragungsrichtung wieder
von dem Signal C(WE) abhängig ist, wird durch das Signal
$M_0$ aus dem Modusregister 10 aktiviert. Abhängig von der
jeweiligen Kombination der Adressenbit $CA_6$ bis $CA_8$ schaltet der Multiplexer 16 eine der Datenleitungen $D'_0$ bis $D'_7$
über den Schreibpuffer 18 auf den Pin $P_9$ oder über Lese-
puffer 19 auf den Pin $P_{10}$ durch.

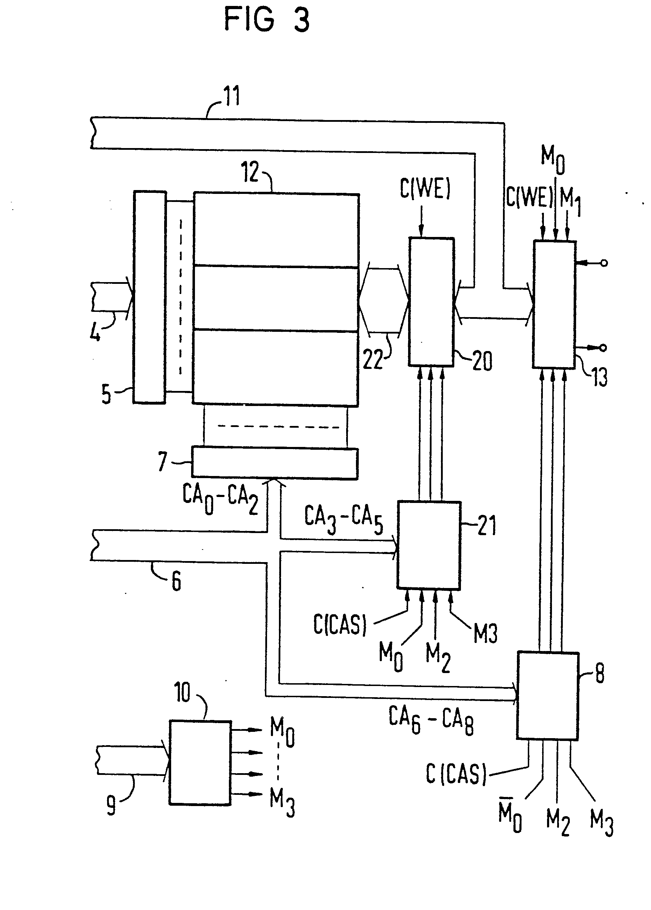

Die Fig. 3 zeigt ein weiteres Ausführungsbeispiel der
Erfindung, wobei in der Zeichnung zur Vereinfachung der
Zwischenspeicher 1 und die Weichenschaltung 3 (Fig. 1) nicht dargestellt sind. Mit diesem Ausführungsbeispiel ist es möglich, neben den schon behandelteBetriebsarten auch noch gekettete Zugriffe mit 8 Bit parallel durchzuführen. Zu diesem Zweck ist zwischen das Speicherfeld 12 und die Multiplexereinrichtung 13 (vergl. auch Fig. 2) ein weiterer Multiplexer 20 für bidirektionalen Betrieb eingefügt. Der Multiplexer 20 wird durch den jeweils aktuellen Stand eines zweiten Adresszählers 21 gesteuert. Das Signal C (WE) bestimmt wieder die Durchlaßrichtung.

Das Speicherfeld 12 ist nunmehr in 8x8 = 64 gleichzeitig adressierbare Bereiche aufgeteilt, die bei insgesamt 512 Spalten jeweils 8 Spalten umfassen würden. Dementsprechend besitzt der Datenbus 22 zwischen dem Speicherfeld 12 und dem Multiplexer 20 64 Leitungen. Der Multiplexer 20 wählt gemäß der von dem zweiten Adresszähler 21 gelieferten aktuellen Spaltenteiladresse 8 Datenbit aus den 64 angebotenen Datenbit aus oder schaltet 8 Datenbit auf 8 der 64 Leitungen im Datenbus durch.

Zur Steuerung des Multiplexers 20 muß der zweite Adresszähler 21 dreistellig ausgeführt sein. In den zweiten Adresszähler 21 wird die aus den Bit $CA_3$ bis $CA_5$ bestehende Spaltenteiladresse durch das Signal $C(RAS)$ eingegeben. An dem entsprechend geänderten Spaltenadressdecoder 7 liegen dann nur noch die Adressenbit $CA_0$ bis $CA_2$ an.

Zur Unterscheidung zwischen geketteten Zugriffen mit je 1 Bit und solchen mit 8 Bit parallel kann das Steuerbit $M_0$ oder M1 im Modusregister herangezogen werden. So erfolgen beispielsweise für $M_0$ = 1 gekettete Zugriffe über die 8-Bit-Datenschnittstelle, wenn gleichzeitig mindestens eines der weiteren Steuerbit $M_2$ oder $M_3$ den logischen Wert 1 hat. In diesem Fall wird der zweite Adresszähler 21 durch die Signalimpulse C(CAS) schrittweise weitergeschaltet, wobei die Anzahl der Zählschritte wieder durch die Steuerbit $M_2$ und $M_3$ bestimmt wird. Der erste Adresszähler 8 ist dabei wegen $\overline{M_0}$=0 an der Modifikation der eingegebenen niederwertigen Adressen $CA_6$ bis $CA_8$ gehindert.

Im einzelnen arbeitet der zweite Adresszähler 21 in der gleichen Weise wie der erste Adresszähler 8. Für die Festlegung der Zählgrenzen kann der ursprünglich dem ersten Adresszähler 8 zugeordnete Impulszähler verwendet werden.

Anstelle von geketteten Zugriffen mit jeweils 8 Bit können auch gekettete Zugriffe mit 9 Bit vorgesehen werden. Es ist auch möglich, den Baustein für gekettete Zugriffe mit je 4 Bit auszubilden. In diesem Fall muß das Adressenbit $CA_6$ in die Zählung einbezogen werden. Grundsätzlich ist auch eine Ausführung für gekettete Zugriffe mit wahlweise 4 oder 8 Bit gleichzeitig möglich.

Es sei noch darauf hingewiesen, daß solche Ausgänge von Schaltungselementen, die mit bidirektional verwendeten Leitungen in Verbindung stehen, immer dann hochohmig sein müssen, wenn die betreffenden Schaltungselemente durch ihre Steuersignale gegen die Weitergabe von Signalen gesperrt sind.

Die Fig. 3 zeigt den zeitlichen Verlauf der Signale, die beim Lesen des Modusregisters 10 an der Peripherie des Speicherbausteins wirksam werden. Es sind dies die Signale $\overline{RAS}$ und $\overline{CAS}$, das Signal MRS, das das Modusregister 10 durch eine entsprechende Wegesteuerung in der Weichenschaltung 3 anwählt und diesbezüglich Vorrang vor den Signalen $\overline{RAS}$ und $\overline{CAS}$ hat, das Schreib/Lese-Auswahlsignal $\overline{WE}$ und die aus dem Modusregister 10 ausgelesene Information an den Pins $P_0$ bis $P_8$. In den schraffierten Bereichen im Verlauf des Signals $\overline{WE}$ ist ein beliebiger Signalpegel zulässig. Die auf dem halben Signalpegel verlaufenden Linien in der letzten Zeile sollen hochohmige Ausgänge bedeuten. Ein niedriger Signalpegel des Signals $\overline{WE}$ gleichzeitig mit dem hohen Pegel des Signals MRS hätte einen Schreibzyklus zur Folge, wobei allerdings unter den als Beispiel angegebenen Voraussetzungen für die Registerbelegung nur die an den Pins $P_0$ bis $P_5$ anliegenden Steuerinformationen eingetragen werden könnten.

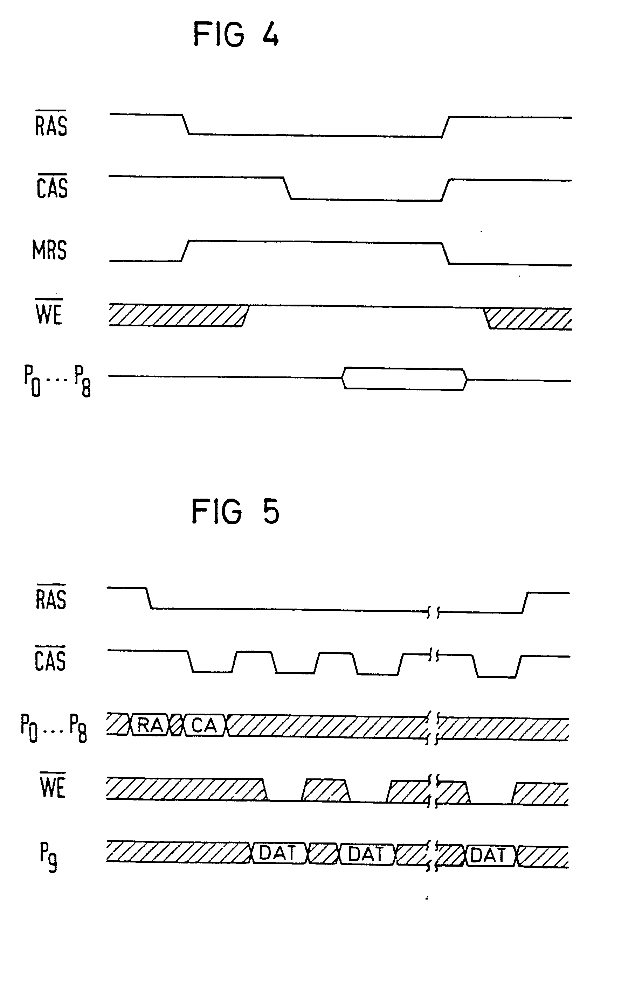

Den zeitlichen Verlauf von Signalen beim Schreiben mit konsekutiven Spaltenadressen und gleichbleibender Zeilenadresse zeigt die Fig. 4. Mit dem Übergang des Übernahmesignals $\overline{RAS}$ auf den niedrigen Signalpegel, entsprechend der logischen Null, wird die an den Pins $P_0$ bis $P_8$ zunächst anliegende Zeilenadresse RA übernommen und an den Zeilenadressdecoder RD weitergeleitet. Kurz darauf geht das Übernahmesignal $\overline{CAS}$ auf den niedrigen Signalpegel über und leitet damit die Übernahme der nunmehr angebotenen Spaltenadresse CA ein. Das Übernahmesignal $\overline{CAS}$ geht sodann wieder in den hohen Signalpegel über. Der erste negative Impuls des Übernahmesignals $\overline{CAS}$ bewirkt auch die Übernahme der drei niederwertigen Bit $CA_6$ bis $CA_8$ in den Adresszähler 8. Die aktuelle Zeilenadresse dient somit als Startadresse für die folgenden Speicherzugriffe, die jeweils allein durch weitere negative Impulse des Übernahmesignals $\overline{CAS}$ ausgelöst werden. Gleichzeitig verursachen der zweite und die folgenden negativen Impulse des Übernahmesignals $\overline{CAS}$ die schrittweise Erhöhung des Zählerstandes des Adresszählers 8 und damit der Teiladresse aus den Adressenbit $CA_6$ bis $CA_8$.

Die dritte Zeile in Fig. 4 stellt den Verlauf des Schreib/Leseauswahlsignals $\overline{WE}$ dar. Mit den zweiten und den folgenden negativen Impulsen des Übernahmesignals $\overline{CAS}$ zeitlich etwa zusammenfallende negative Impulse des Signals $\overline{WE}$ haben zur Folge, daß das an dem Anschlußpin $P_9$ des Speicherbausteins anliegende Bit DAT eingeschrieben wird.

Fehlende negative Impulse des Signals $\overline{WE}$ würden Lesevorgänge bewirken. In diesem Fall würden die ausgelesenen Bit an dem Anschlußpin $P_{10}$ mit einem der Zugriffszeit entsprechenden zeitlichen Versatz anliegen.

Für das zur Steuerung des Zugriffs zum Modusregister 10 erforderliche Steuersignal MRS wird ein zusätzlicher peripherer Anschluß benötigt. Bei einem Bausteingehäuse mit zweireihig angeordneten Anschlußfahnen (dual-in-line-package) kann das eine Erhöhung der Zahl der Anschlußfahnen um zwei gegenüber einer sonst gleichen Bausteinausführung ohne zusätzlich wählbare Betriebsfunktionen zur Folge haben. Beispielsweise müßte ein 18-Pin-Gehäuse anstatt eines 16-Pin-Gehäuses eingesetzt werden. Damit könnte aber ein solcher Speicherbaustein nicht mehr ohne weiteres gegen einen Speicherbaustein konventioneller Bauart ausgetauscht werden, obwohl im übrigen eine volle Kompatibilität besteht. Es ist aber auch möglich, ein gemäß der Erfindung ausgebildetes Speicherchip in ein Gehäuse mit 16 Pins einzubauen, wenn der Anschluß für das Steuersignal MRS bausteinintern an ein geeignetes Festpotential, im Fall der beschriebenen Ausführungsbeispiele an ein der logischen Null entsprechendes Potential angelegt wird. Selbstverständlich geht dann die Möglichkeit, zusätzliche Betriebsarten zu wählen, verloren.

Obgleich die vorstehend beschriebenen Ausführungsbeispiele der Erfindung von einem dynamischen Speicherbaustein in Unipolartechnik ausgehen, ist die Erfindung ohne weiteres auch für statische Speicherbausteine oder solche in Bipolartechnik anwendbar.

5 Figuren
3 Patentansprüche

Patentansprüche

1. Integrierter Speicherbaustein mit durch Zeilen- und Spaltenadressen adressierbaren, matrixartig angeordneten Speicherzellen, mit einer für die Adressensignale erforderlichen Anzahl von Adressen-Eingangsanschlüssen, mit einem mit den Adressen-Eingangsanschlüssen verbundenen Adressen-Pufferspeicher zur Übernahme jeweils einer Adresse durch Adressenübernahmesignale und mit einem Zeilenadressdecoder und einem Spaltenadressdecoder zur Bildung von Zeilen- und Spaltenauswahlsignalen sowie mit einem Dateneingang und einem Datenausgang, d a d u r c h  g e k e n n z e i c h n e t,
daß ein über die Adressen-Eingangsanschlüsse ($P_0$ bis $P_8$) ladbares bzw. lesbares Modusregister (10) zur Aufnahme von die Betriebsfunktion des Speicherbausteins bestimmenden Informationen vorgesehen ist,
daß die Einrichtungen für die Adresseneingabe sowie für die Dateneingabe und Datenausgabe für bidirektionalen Betrieb ausgebildet sind,
daß das Speichermedium (12) in n jeweils eine gleiche Anzahl von Spalten umfassende Bereiche aufgeteilt ist, zu denen gleichzeitig zugreifbar ist und
daß an den Adressen-Pufferspeicher (1) eine Weichenschaltung (3) zur wahlweisen, teilweise bidirektionalen Verbindung des Adressen-Pufferspeichers (1) mit den Adressdecodern (5, 7), mit dem Modusregister (10) und mit einem bausteininternen Datenbus (11) angeschlossen ist, wobei die n Leitungen des Datenbusses (11) mit den Schreib/Lese-Leitungen der durch einen höherwertigen Teil ($CA_0$ bis $CA_5$) der Spaltenadresse vorausgewählten Speicherzellen identisch sind.

2. Speicherbaustein nach Anspruch 1, d a d u r c h  g e k e n n z e i c h n e t, daß ein mit dem niedrigstwertigen Teil (z. B. $CA_6$ bis $CA_8$) der Spaltenadresse (CA) ladbarer erster Adresszähler (8) vorgesehen ist, dessen Stand durch Impulse des Spaltenadressen-Übernahme-signals ($\overline{CAS}$) schrittweise erhöht wird, und daß ferner eine Multiplexereinrichtung (13 bzw. 16) vorgesehen ist, die gemäß dem jeweiligen Stand des ersten Adresszählers (8) eine Verbindung des Dateneingangsanschlusses ($P_9$) bzw. des Datenausgangsanschlusses ($P_{10}$) mit einer von n durch die Zeilenadresse (RA) und den höherwertigen Teil der Spaltenadresse ($CA_0$ bis $CA_5$) vorausgewählten Speicher-zellen herstellt.

3. Speicherbaustein nach Anspruch 2, d a d u r c h   g e -
k e n n z e i c h n e t, daß jeder der n Bereiche des Speichermediums (12) in k durch den höchstwertigen Teil (z. B. $CA_0$ bis $CA_2$) der Spaltenadresse (CA) gleichzeitig adressierbare, gleichgroße Unterbereiche aufgeteilt ist, daß ein mit dem Teil ($CA_3$ bis $CA_5$) mittlerer Wertigkeit der Spaltenadresse (CA) ladbarer zweiter Adresszähler (21) vorgesehen ist, dessen Stand alternativ zum Stand des ersten Adresszählers (8) durch Impulse des Spaltenadressen-Übernahmesignals ($\overline{CAS}$) schrittweise erhöht wird, und daß ein weiterer Multiplexer (20) vorgesehen ist, der gemäß dem jeweiligen Stand des zweiten Adresszählers (21) Verbindungen zwischen den Leitungen des Datenbusses (11) und jeweils k Schreib/Lese-Leitungen eines der n Bereiche des Speichermediums (12) herstellt.

FIG 1

FIG 2

0030007

2/4

FIG 3

## FIG 4

$\overline{RAS}$

$\overline{CAS}$

MRS

$\overline{WE}$

$P_0 \cdots P_8$

## FIG 5

$\overline{RAS}$

$\overline{CAS}$

$P_0 \cdots P_8$  RA  CA

$\overline{WE}$

$P_9$  DAT  DAT  DAT